## Europäisches Patentamt
## European Patent Office
## Office européen des brevets

(19)

(11) Publication number: **0 098 724**
A1

(12) **EUROPEAN PATENT APPLICATION**

(21) Application number: **83303703.9**

(22) Date of filing: **27.06.83**

(51) Int. Cl.³: **C 30 B 11/10**

(30) Priority: **25.06.82 JP 110535/82**

(43) Date of publication of application: **18.01.84**
Bulletin 84/3

(84) Designated Contracting States: **CH DE FR GB LI NL**

(71) Applicant: **SUMITOMO CHEMICAL COMPANY, LIMITED, 15 Kitahama 5-chome Higashi-ku, Osaka-shi Osaka-fu (JP)**

(72) Inventor: **Hashimoto, Tadanori, 2-12 Tennochi, Takatsuki Osaka-fu (JP)**
Inventor: **Hama, Masaaki, 10-4-446, Sone Higashimachi, 2-chome, Toyonaka Osaka-fu (JP)**
Inventor: **Watanabe, Keiichirou, 11-7-508, Sone Higashimachi, 2-chome, Toyonaka Osaka-fu (JP)**

(74) Representative: **Geering, Keith Edwin et al, REDDIE & GROSE 16 Theobalds Road, London WC1X 8PL (GB)**

(54) **Single crystal production.**

(57) A Verneuil-type fusion method for producing a single crystal from free-flowing particulate crystallisable material (e.g. alumina) by continuously dropping the particles separately into a flame or like fusion zone and depositing the resulting molten particles to grow in single crystal form, wherein the particulate material is in spherically granular form, preferably of 5 to 200 μm diameter.

EP 0 098 724 A1

-1-

## SINGLE CRYSTAL
## PRODUCTION

The present invention relates to a method for producing single crystals.

Various methods for producing single crystals have so far been devised and put to practical use. One known method is a flame fusion method called Verneuil's method; in this the material to be crystallised is dropped in powder form through a flame (e.g. oxygen/hydrogen) and the molten material is accumulated on a receiver on which the single crystal grows up gradually; the powder passes into the flame through a sieve at the bottom of a container of the powder, the container being vibratable. This method uses no crucibles, so that there is little contamination with impurities in the course of crystal growth; and it can give larger single crystals in a shorter time than other methods. Because of this, single crystals of alumina ($Al_2O_3$), spinel ($MgAl_2O_4$), rutile ($TiO_2$), strontium titanate (SrTiO), yttrium-aluminum-garnet ($Y_3Al_5O_{12}$) and gadolinium-gallium-garnet ($Gd_3Ga_5O_{12}$) types are now produced in large quantities by this method not only as artificial jewels but also as industrial materials such as abrasion-resistant materials (e.g. bearings, wrist watch glasses) and laser materials.

Verneuil's method however, has the defect that single crystals cannot be obtained unless the powder falls uniformly through the sieve without blocking. The powder material used must therefore have good flowability in addition to high purity and easy fusibility; there has so far been used powder having a fine particle size of not more than 1 μm intended for easy fusibility and a low bulk density intended for good flowability. For example, for alumina-type single crystals, there is in use a scaly γ-alumina powder obtained by thermal decomposition of ammonium alum at about 1000°C. This powder, because of its scaly form, is not prone to cause blocking in the container, showing good flowability; because of its very low bulk density, however, it requires a container so large that applying vibration is difficult and the accuracy of the amount of powder passing through the sieve can be poor; furthermore, because the powder is very light, considerable quantities may be blown off to the surroundings during passage through the flame, whereby the yield of single crystal from the expensive material can be poor. In addition, the powder obtained by thermal decomposition of ammonium alum has a very wide particle size distribution, and must first be sieved to remove oversize particles, further reducing the yield of single crystal from the initial material. The conventional method described above tries to secure flowability at the expense of the yield from the expensive powder, but even so flowability varies widely between production lots due to the great difficulty in obtaining powder materials of constant particle shape by the conventional thermal decomposition of ammonium alum, and the low bulk density makes handling difficult. It has therefore been very difficult to produce standardised single crystals.

The present invention provides a powder fusion method for single crystal production in which spherically granulated material is used as the powder. The yield of single crystal can thereby be improved (compared to that using the prior scaly material) because the spherically granulated starting material has high bulk density as well as good flowability; furthermore single crystals of uniform good quality can be obtained because the powder material used has uniform flowability.

One method for spherically granulating a material for single crystal formation comprises granulating a slurry comprising the powder material and a liquid carrier (e.g. water or organic solvent) on a spray drier or fluidizing drier. Granulation by spray drier is particularly preferred in terms of the particle size of granules obtained. The particle size of the granule can optionally be selected according to the flowability and ease of fusibility required. A particle size between 5 and 200 μm is preferred because granules below 5 μm may tend to fly about whilst passing through the fusion zone (e.g. flame), resulting in poor yields, and granules above 200 μm may take too long to fuse - e.g. until after contacting the single crystal growing portion.

The slurry of powder material for use in granulation can be prepared using conventional equipment, e.g. stirrers, ball mills, and ultrasonic dispersing machines.

Materials to which the method of the present invention can be applied include not only the powdery material previously used in Verneuil's method, but also powdery materials which could not be previously used because of poor flowability. Various additives may be incorporated to impart colour or for other functions provided that the effect of the present invention is not destroyed. For obtaining good quality single crystals, however, it is desirable to limit the amount of additive to less than 5% by weight. Examples of materials suitable for use in spherically granulated form in the present invention include alumina ($Al_2O_3$), spinel ($MgAl_2O_4$), rutile ($TiO_2$), strontium titanate ($SrTiO_3$), yttrium-aluminum-garnet ($Y_3Al_5O_{12}$) and

gadolinium-gallium-garnet ($Gd_3Ga_5O_{12}$) types of which the content of main component is preferably at least 95% by weight. It is particularly preferred, in terms of the ease of material preparation, to apply the present invention to alumina single crystals. The purity of the powdery materials and additives used largely affects the quality of single crystals obtained, so that it is desirable to use products of as high purity as possible. Preferably the powdery materials which are a main component should have a purity of at least 99.9% by weight. Alumina single crystals of particularly good quality can be obtained when high purity materials(of not less than 99.99% by weight purity)are used.

The method of the present invention is suitably performed using the apparatus already known for use in Verneuil's single crystal production method.

The present invention is illustrated more specifically by the following Examples and comparative examples, but is not to be interpreted as limited to these examples. All percents in the examples are by weight.

Example 1

One kilogram of α-alumina having a particle size of 0.5 μm and a purity of 99.99% (produced by Sumitomo Chemical Co.) and 1.5 kg. of water were mixed into a slurry by an alumina-made ball mill. This slurry was granulated on a rotary disk type spray drier to obtain 0.98 kg. of spherical granules having an average particle size of 60 µm. The spherical α-alumina granules thus obtained had a bulk density as high as 0.8 g/cm$^3$, did not fly, and were easily handled as well as of very good flowability. Using these alumina granules as material in the apparatus commonly used in Verneuil's single crystal producing method, a white sapphire single crystal was produced at a growth rate of 20 mm/hr while using oxygen and hydrogen gases at mixing/combustion rates of 0.3 m$^3$/hr and 1.5 m$^3$/hr, respectively. The single crystal obtained was of very good quality with no material attached to its surface. The yield of single crystal from the α-alumina granules was as high as 96%.

Example 2

One kilogram of γ-alumina having a particle size of 0.05 µm and a purity of 99.99% obtained by calcination of aluminum hydroxide (produced by Sumitomo Chemical Co.) and 5.5 kg. of water were mixed into a slurry by an alumina-made ball mill. This slurry was granulated on a two-fluid nozzle type spray drier to obtain 0.95 kg. of spherical granules having an average particle size

of 40 μm.  The spherical γ-alumina granules thus obtained had a bulk density as high as 0.8 g/cm$^3$, did not fly   and were easily handled as well as of very good flowability.  Using these granules, a white sapphire single crystal was produced in the same manner as in Example 1.  The single crystal obtained was of very good quality with no material attached to its surface.  The yield of single crystal from the γ-alumina granule was as high as 95%.

Comparative example 1

By thermal decomposition of ammonium alum was produced γ-alumina of particle size 0.05 μm, bulk density 0.2 g/cm$^3$ and 99.99% purity, comprising powder agglomerates having a scaly form and an average agglomerate size of 80 μm.  This γ-alumina powder was very difficult to handle because it tended to fly   when transferred from one container to another.  Using this γ-alumina powder, single crystals were produced in the same manner as in Example 1, but the single crystal obtained had alumina powder attached to its whole surface.  The yield of single crystal from the γ-alumina powder was as low as 80%.

Comparative example 2

The production of sapphire single crystals was tried with the same apparatus as in Example 1,

using the same γ-alumina powder as in Example 2 produced from aluminum hydroxide but not granulated. This non-granulated γ-alumina powder was of low flowability and hardly fell down into the oxygenhydrogen flame so that a single crystal did not grow at all.

Example 3

In the slurry preparation in Example 1, 2% of $Cr_2O_3$ powder having a particle size of 0.5 μm (produced by Nippon Kagaku Kōgyō Co.) was added to the high purity α-alumina powder. The mixture was granulated on a rotary disk type spray drier to obtain spherical granules having an average particle size of 60 μm. The $Cr_2O_3$-containing alumina granules thus obtained had a bulk density as high as 0.8 $g/cm^3$, did not fly and were easily handled as well as of very good flowability because of the spherical form. Using these granules, a ruby single crystal was produced under the same heating conditions as in Example 1 and at a growth rate of 15 mm/hr. The single crystal obtained was of very good quality, and the yield of single crystal was as high as 96%.

Whilst the method of the present invention has been described in use with apparatus of the Verneuil's crystal growth method, wherein the powder is e.g. released from a tube coaxial with the combustion gas supply and directly into the flame for fusion, other similar apparatus for single crystal growth may be used within the scope of the invention. Similarly, whilst the invention has been described utilising an oxygen/hydrogen flame for powder fusion, other suitable gaseous combustion mixtures or other heating methods may be used.

CLAIMS :

1.    A fusion method for producing a single crystal from free-flowing particulate crystallisable material by continuously introducing the particles separately into a heat fusion zone and depositing the resulting molten particles to grow in single crystal form, characterised in that the particulate material is in spherically granular form.

2.    A method according to claim 1 characterised in that the spherically granular material is prepared by spray drying.

3.    A method according to claim 1 or 2 wherein the granules have a diameter of 5 to 200 μm.

4.    A method according to any preceding claim wherein not less than 95% by weight of the granular material consists of one or more members selected from alumina ($Al_2O_3$), spinel ($MgAl_2O_4$), rutile ($TiO_2$), strontium titanate ($SrTiO_3$), yttrium-aluminum-garnet ($Y_3Al_5O_{12}$) and gadolinium-gallium-garnet ($Gd_3Ga_5O_{12}$).

5.    A method according to claim 1, 2 or 3 wherein the alumina content of the material used for the single crystal formation is not less than 95% by weight.

6.      A method according to claim 5 wherein alumina having a purity of not less than 99.9% by weight is used.

7.      A method according to any preceding claim wherein the fusion zone is provided by a flame.

8.      A method according to claim 7 wherein the fusion zone is provided by a hydrogen/oxygen flame.

9.      A Verneuil's flame fusion method for single crystal production characterised in that the crystallisable feed material is in spherical granular form.

10.      A flame fusion method for producing single crystals by passing the crystallisable material in particulate form through a flame and depositing the resulting molten particles to grow in single crystal form, characterised in that the particulate material is used in spherically granular form.

## European Patent Office

## EUROPEAN SEARCH REPORT

Application number

EP 83 30 3703

| | DOCUMENTS CONSIDERED TO BE RELEVANT | | |
|---|---|---|---|
| Category | Citation of document with indication, where appropriate, of relevant passages | Relevant to claim | CLASSIFICATION OF THE APPLICATION (Int. Cl. ³) |
| X | FR-A-2 038 158 (CESKOSLOVENSKA AKADEMIE VED.) * Page 2, lines 17-40; claims * | 1-10 | C 30 B 11/10 |
| X | FR-A-2 232 361 (PREUSSAG AG) * Claims * | 1,4,5, 9,10 | |
| X | FR-A-1 432 731 (G. PETIT-LE DU) * Claims * | 1,4,5, 9,10 | |

TECHNICAL FIELDS
SEARCHED (Int. Cl. ³)

C 30 B 11/10

The present search report has been drawn up for all claims

| Place of search THE HAGUE | Date of completion of the search 06-10-1983 | Examiner BRACKE P.P.J.L. |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document